Europäisches Patentamt

**European Patent Office**

Office européen des brevets

(11) Veröffentlichungsnummer: **0 211 213**
**B1**

(12) **EUROPÄISCHE PATENTSCHRIFT**

(45) Veröffentlichungstag der Patentschrift:
03.10.90

(21) Anmeldenummer: 86108603.1

(22) Anmeldetag: 24.06.86

(51) Int. Cl.⁵: **H03J 3/14**, H03K 5/153

(54) **Anordnung zur Überwachung eines PCM- oder DS-Geräts oder eines Digitalsignal-Kanalverteilers für n-bit-Multiplexsignale.**

(30) Priorität: 27.06.85 DE 3523037

(43) Veröffentlichungstag der Anmeldung:
25.02.87 Patentblatt 87/9

(45) Bekanntmachung des Hinweises auf die Patenterteilung:
03.10.90 Patentblatt 90/40

(84) Benannte Vertragsstaaten:
AT BE CH DE FR GB IT LI NL SE

(56) Entgegenhaltungen:
DE-B- 2 719 223
FR-A- 2 200 690
US-A- 3 541 456
US-A- 3 950 705
US-A- 3 996 423

TECHNISCHE RUNDSCHAU, Band 68, Nr. 51, 14.
Dezember 1976, Seiten 9-11, Bern, CH; P. BLOMEYER:
"Kleines LSL-Praktikum"
PATENTS ABSTRACTS OF JAPAN, Band 2, Nr. 134, 9.
November 1978, Seite 8273 E 78; & JP-A-53 101 922 (OKI
DENKI KOGYO K.K.) 05-09-1978
ELECTRONIC DESIGN, Band 24, Nr. 22, 25.
Oktober 1976, Seite 192, Rochelle Park, US; L.
LANGSTON: "Simple circuit detects data edges;
advanced circuit provides complex outputs"

(73) Patentinhaber: Siemens Aktiengesellschaft,
Wittelsbacherplatz 2, D-8000 München 2(DE)

(72) Erfinder: Nirschl, Heinrich, Dipl.-Ing.,
Rotkäppchenstrasse 56, D-8000 München 83(DE)

## Beschreibung

Die Erfindung bezieht sich auf eine Anordnung zur Überwachung eines Pulscodemodulations(PCM)- oder Digitalsignal(DS)-Geräts oder eines Digitalsignal-Kanalverteilers für n-bit-Multiplexsignale.

Nach dem "Pflichtenheft für Fehler und Störungssignalisierung für PCM- und DS-Geräte" der Deutschen Bundespost, Fernmeldetechnisches Zentralamt, Referat N12, FTZ 153 Pfl..., Ausgabe 2, werden bestimmte wichtige Funktionen eines Anlageteils mit Hilfe besonderer Überwachungsschaltungen in den Geräten überwacht. Spricht eine derartige Überwachungsschaltung an, dann wird in dem fehlererkennenden Gerät eine besondere Leuchtdiode zum Leuchten gebracht und eine Fehlermeldung zu einem Signal im Gestell abgegeben. In der Regel werden mehrere Geräte an dasselbe Signalfeld angeschaltet, wobei die Fehlermeldungen dieser Geräte an gemeinsame Leitungen abgegeben werden.

Nach Dringlichkeit der Fehlerbehebung unterscheidet man zwei Wertigkeitsstufen für Fehleralarme: A-Alarm = dringender Alarm, dieser muß sofort, auch außerhalb der Regelarbeitszeit, d.h. auch nachts und feiertags bearbeitet werden; B-Alarm = nicht dringender Alarm, dessen Bearbeitung ist nur innerhalb der Regelarbeitszeit erforderlich. Die Wertigkeit der Fehlermeldungen muß an den Geräten durch Schaltbrücken auf unterschiedliche Signalleitungen (A/AZ oder B/BZ) geschaltet werden können. Solange der fehlerhafte Zustand andauert, wird im meldenden Gerät eine Leuchtdiode zum Leuchten gebracht und an die Signalleitung AZ (für A-Alarme) oder BZ (für B-Alarme) Erdpotential angelegt. Der Beginn des fehlerhaften Zustands wird zusätzlich durch Senden eines Impulses auf die Signalleitung A oder B gemeldet. Im Signalfeld wird daraufhin eine Alarmlampe A oder B zum Leuchten gebracht und der Alarmzustand über Alarmleitungen an die Lichtzeicheneinrichtung im Gestellreihenseitenteil weitergemeldet und dort ebenfalls eine Alarmlampe A oder B zum Leuchten gebracht.

Die Alarmmeldung kann durch Drücken einer Quittiertaste im Signalfeld abgeschaltet werden. Zur Erinnerung leuchtet danach anstatt der Alarmlampen A oder B eine Erinnerungsalarmlampe EL im Signalfeld und in der Lichtzeicheneinrichtung. Diese Erinnerung-Alarmlampe EL kann auch leuchten, wenn ein Schalter oder Stecker in einem Gerät nicht in betriebsmäßigem Zustand ist.

Die Alarmausgänge A und B und die Erinnerungslampen EL aller Signalfelder einer Gestellreihe und schließlich die Alarmausgänge aller Lichtzeicheneinrichtungen werden zu einem einzigen Fehlersammelsignal zusammengefaßt. An einem zentralen Betriebsbeobachtungsplatz kann daher nur erkannt werden, ob in einer Betriebsstelle irgendein Anlageteil eine Fehlermeldung abgibt.

Die Erinnerungslampe im Signalfeld und die Lichtzeicheneinrichtungen leuchten so lange, wie eine Fehlermeldung aus einem Gerät abgegeben wird und damit eine der Zustandsleitungen AZ oder BZ Erdpotential aufweist oder solange ein Schalter oder Stecker nicht im betriebsmäßigen Zustand ist und vom betroffenen Gerät bereits Erdpotential an die Erinnerungslampe EL angelegt wird.

Bei Multiplexgeräten muß für eine Fehlermeldung "Ausfall des Signals an F2 an (Eingang)" jeder Eingang unabhängig von den anderen Eingängen eine neue Fehlermeldung an das Signalfeld abgeben können, auch wenn bereits eine Fehlermeldung eines Eingangs besteht und quittiert wurde, d.h. auf die Sammelleitung A oder B zum Signalfeld muß bei erneutem Fehler ein Puls abgegeben werden, auch wenn die Zustandsleitung (AZ oder BZ) noch aktiviert ist.

Bei einem bekannten Multiplexgerät sind für Fehlermeldungen aus jedem Kanal je ein Eingang eines ODER-Gatters vorgesehen, dessen Ausgang mit der Signalleitung AZ bzw. BZ unmittelbar und mit der Signalleitung A bzw. B über einen Pulsformer verbunden sind.

Aus der Patentschrift US-A 3 996 423 ist eine Anordnung zur gruppenweisen Überwachung von Zeitmultiplex-Digitalsignalen und zur Alarmierung mit Einrichtungen zur Rahmensynchronisierung und Alarmierung bei örtlichen oder äußeren Störungen bekannt.

Aus der Patentanmeldung FR-A 2 200 690 ist schließlich eine Impulsumformerschaltung bekannt, bei der ein Signal sowohl direkt als auch über einen oder drei Inverter jeweils einem Eingang eines UND-Gatters zugeführt wird.

Aufgabe der Erfindung ist es, eine Überwachungsanordnung mit einfachen Anordnungen zur Erkennung einer logischen Zustandsänderung entweder von einem niedrigen Wert zu einem hohen Wert oder umgekehrt in einem Kanal eines n-bit-Multiplexsignals anzugeben.

Bei einer derartigen Überwachungsanordnung wird diese Aufgabe erfindungsgemäß dadurch gelöst, daß Fehler- und Störerkennungseinrichtungen vorgesehen sind, daß eine Verknüpfungseinrichtung vorgesehen ist, die über einen Alarmbus mit den Fehler- und Störerkennungseinrichtungen verbunden ist, daß eine erste Zeitbewertungseinrichtung vorgesehen ist, die A-Alarme von der Verknüpfungseinrichtung empfängt, daß eine zweite Zeitbewertungseinrichtung vorgesehen ist, die B-Alarme von der Verknüpfungseinrichtung empfängt, daß eine erste Anordnung zur Erkennung einer logischen Zustandsänderung vorgesehen ist, deren Eingang mit dem Ausgang der ersten Zeitbewertungseinrichtung verbunden ist, daß eine zweite Anordnung zur Erkennung einer logischen Zustandsänderung vorgesehen ist, deren Eingang mit dem Ausgang der zweiten Zeitbewertungseinrichtung verbunden ist, daß in beiden Anordnungen jeweils ein n-bit-Schieberegister, dessen Eingang als Gesamteingang dient und das einen Multiplextakteingang aufweist, ein UND-Gatter, dessen erster Eingang – für eine Erkennung einer logischen Zustandsänderung von einem niedrigen Wert zu einem hohen Wert – unmittelbar mit dem Gesamteingang und dessen zweiter Eingang über einen Inverter mit dem Ausgang des n-bit-Schieberegisters verbunden ist und dessen erster Eingang – für eine Erkennung einer logischen Zustandsänderung von einem hohen Wert zu einem niedrigen Wert – über einen Inverter mit dem Gesamteingang und dessen zweiter Eingang unmitelbar mit dem Ausgang des n-bit-Schieberegisters verbunden ist, und ferner ein D-Flip-Flop vorgesehen sind, dessen Eingang mit dem Ausgang des UND-Gatters und dessen Takteingang mit dem Multiplextakteingang verbunden ist und dessen Ausgang als Gesamtausgang dient, daß ein erster Umsetzer vorgesehen ist, dessen Eingang mit dem Ausgang der ersten Anordnung zur Erkennung einer logischen Zustandsänderung, dessen erster Ausgang mit einer A-Alarmimpuls-Signalleitung und dessen zweiter Ausgang mit einer A-Daueralarm-Signalleitung verbunden ist, und daß ein zweiter Umsetzer vorgesehen ist, dessen Eingang mit dem Ausgang der zweiten Anordnung zur Erkennung einer logischen Zustandsänderung, dessen erster Ausgang mit einer B-Alarmimpuls-Signalleitung und dessen zweiter Ausgang mit einer B-Daueralarm-Signalleitung verbunden ist.

Die Anzeige einer ansteigenden Flanke eines Bits im Multiplexsignal bei der einen Anordnungsvariante und die Anzeige einer abfallenden Flanke eines Bits im Multiplexsignal bei der anderen Anordnungsvariante erfolgt damit unabhängig vom Zustand der anderen Bits im Multiplex-Signal.

Vorteilhaft ist die Verwendung der erfindungsgemäßen Anordnung bei der Fehlersignalisierung für PCM- und DS-Geräte sowie Digitalsignal-Kanalverteiler, weil die Forderungen des eingangs genannten Pflichtenheftes mit dieser in einfacher Weise erfüllbar sind.
Anhand der Zeichnungen wird die Erfindung nachstehend näher erläutert:

Figur 1 zeigt eine Anordnung zur Erkennung einer logischen Zustandsänderung von einem niedrigen Wert zu einem hohen Wert in einem Kanal eines n-bit-Multiplexsignals,
Figur 2 zeigt eine Anordnung zur Erkennung einer logischen Zustandsänderung von einem hohen Wert zu einem niedrigen Wert in einem Kanal eines n-bit-Multiplexsignals,
Figur 3 zeigt eine erfindungsgemäße Anordnung in der Überwachungsschaltung eines Digitalsignal-Kanalverteilers,
Figur 4 zeigt detailliert eine Verknüpfungseinrichtung nach Figur 3.
Figur 5 zeigt detailliert eine Zeitbewertungseinrichtung nach Figur 3 und
Figur 6 zeigt detaillierter eine Anordnung nach Figur 1 mit einem anschließenden Umsetzer.

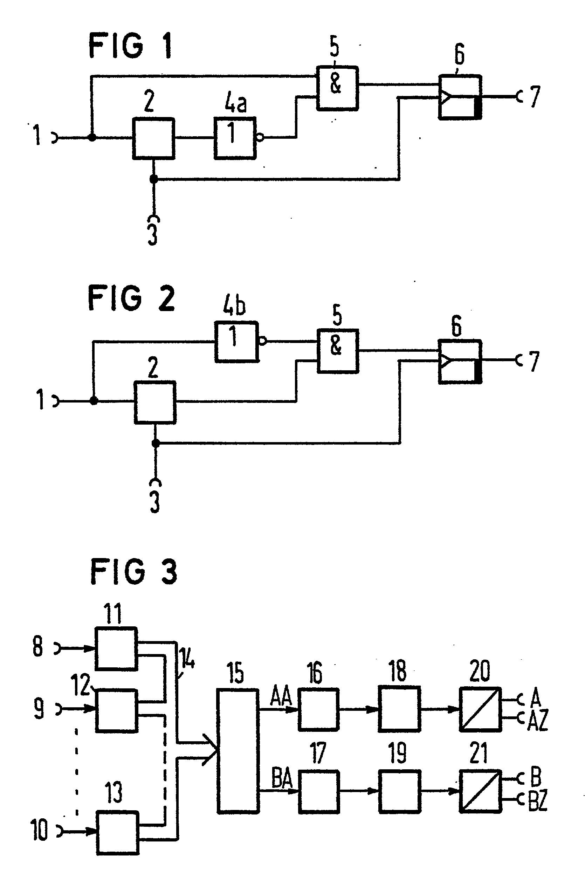

Figur 1 zeigt eine Anordnung zur Erkennung einer logischen Zustandsänderung von einem niedrigen Wert zu einem hohen Wert in einem Kanal eines n-bit-Multiplexsignals. Sie enthält einen Eingang 1, ein n-bit-Schieberegister 2, einen Multiplextakteingang 3, einen Inverter 4a, ein UND-Gatter 5, ein D-Flipflop 6 und einen Ausgang 7.
Ein an den Eingang 1 angelegtes n-bit-Multiplexsignal wird gleichzeitig mit dem Eingang des n-bit-Schieberegisters 2 und dem nichtinvertierenden Eingang des UND-Gatters 5 verbunden. Mit dem Multiplextakteingang 3 wird das n-bit-Multiplexsignal durch das n-bit-Schieberegister 2 hindurchgeschoben. An den Eingängen des UND-Gatters 5 liegen demzufolge die Bits desselben Kanals in zwei aufeinanderfolgenden Pulsrahmen an. Hat das neue Bit einen logischen Zustand hohen Wertes und das alte einen logischen Zustand niedrigen Werts, so gibt das UND-Gatter 5 einen Impuls an das D-Flipflop 6 ab, das diesen mit dem Multiplextakt an den Ausgang 7 abgibt.

Figur 2 zeigt eine Anordnung zur Erkennung einer logischen Zustandsänderung von einem hohen Wert zu einem niedrigen Wert in einem Kanal eines n-bit-Multiplexsignals. Die Anordnung nach der Figur 2 unterscheidet sich von der nach der Figur 1 lediglich dadurch, daß der Inverter 4b dem anderen Eingang des UND-Gatters vorgeschaltet ist. Ansonsten ist die Wirkungsweise der Anordnung dieselbe.

Figur 3 zeigt eine erfindungsgemäße Überwachungseinrichtung, in der die oben beschriebenen Anordnungen 18 und 19 verwendet sind. Die Einrichtung enthält weiter Fehler- und Störungserkennungseinrichtungen 11 - 13 mit 2-Mbit/s-Eingängen 8 - 10 von verschiedenen Geräten. Diese Fehler- und Störungserkennungseinrichtungen 11 - 13 sind über einen Alarmbus 14 mit einer Verknüpfungseinrichtung 15 verbunden, die einen A-Alarm AA und einen B-Alarm BA abgeben kann. Der A-Alarm AA gelangt über eine Zeitbewertungseinrichtung 16 und die erfindungsgemäße Anordnung 18 zu einem Umsetzer 20, der auf eine Signalleitung A einen Alarmimpuls und auf die Signalleitung AZ einen Daueralarm gibt. Entsprechend gelangt ein B-Alarm BA über eine Zeitbewertungseinrichtung 17 und die erfindungsgemäße Anordnung 19 zu einem Umsetzer 21, der einen Alarmimpuls auf eine Signalleitung B und einen Daueralarm auf eine Signalleitung BZ gibt. Die Fehler- und Störungserkennungseinrichtungen 11 - 13 können mit einem integrierten Baustein PEB 2030 der Fa. Siemens realisiert werden.

Diese Überwachungseinrichtung vermag die eingangs genannten Forderungen der Deutschen Bundespost aus dem zitierten Pflichtenheft zu erfüllen. Die Fehler- und Störungserkennungseinrichtungen 11 - 13 erkennen Fehler in den an den Klemmen 8 - 10 anliegenden 2-Mbit/s-Signalen und geben Fehlermeldungen in Form von Multiplexsignalen an die Verknüpfungseinrichtung 15 ab. Dort werden diese ausgewertet und als dringende Alarme AA oder nicht dringende Alarme BA in Form von Multiplexsignalen zu den Zeitbewertungseinrichtungen 16 und 17 weitergeleitet, wo sie erst nach Zeitabständen von 150 ms bis 600 ms an die erfindungsgemäßen Anordnungen 18 und 19 zur Flankenerkennung immer noch in Form von Multiplexsignalen weitergegeben werden. Die Ausgangssignale der erfindungsgemäßen Anordnungen steuern die Umsetzer 20 und 21 an, die bei Beginn eines fehlerhaften Zustandes einen Impuls auf die Signalleitungen A oder B aussenden und gleichzeitig Dauerimpulse auf die Signalleitungen AZ und BZ geben, die an einem zentralen Betriebsbeobachtungsplatz erkannt werden.

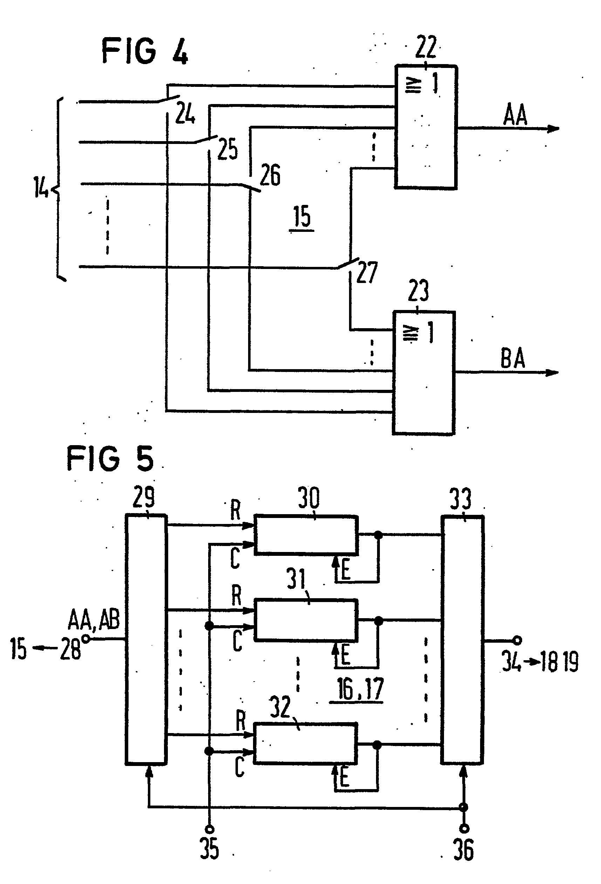

Figur 4 zeigt die Verknüpfungseinrichtung 15 nach Figur 3. Diese enthält ODER-Gatter 22,23 sowie Umschalter 24 bis 27. Wie in Figur 3 gezeigt ist eingangsseitig der Alarmbus 14 angeschlossen, ausgangsseitig sind Ausgänge für den A-Alarm und den B-Alarm vorgesehen. Die Umschalter 24 bis 27 bieten die Möglichkeit, einzelne Alarme auf dem Alarmbus 14 entweder dem Ausgang für den A-Alarm oder den Ausgang für den B-Alarm zuzuordnen.

Figur 5 zeigt detailliert eine Zeitbewertungseinrichtung 16 oder 17 nach Figur 3. Diese Anordnung enthält einen Eingang 28, einen n-bit-Demultiplexer 29, einen n-bit-Multiplexer 33 einen Multiplexadreßeingang 36 und einen Ausgang 34. Weiter sind Zähler 30 bis 33 vorhanden, deren Rücksetzeingänge R mit jeweils einem Ausgang des n-bit-Demultiplexers 29, deren Takteingänge C mit dem gemeinsamen Takteingang 35 und deren Ausgänge und Freigabe-Eingänge E jeweils mit einem Eingang des n-bit-Multiplexers 33 verbunden sind. Die aufgeführten Bausteine sind handelsüblich.

Ein an den Takteingang 35 angelegter zeitbestimmender Takt bewirkt, daß die Zähler 30 bis 33 zu zählen beginnen, wenn eine Fehlermeldung vorliegt. Ist im n-bit-Multiplexsignal am Eingang 28 keine Fehlermeldung enthalten, dann werden die Zähler 30 bis 33 von den Ausgangssignalen des n-bit-Demultiplexers 29 periodisch zurückgesetzt. Lediglich dann, wenn in einem oder mehreren Kanälen ein Fehlersignal auftaucht, bleibt die Rücksetzung aus und die betroffenen Zähler zählen bis zu ihrem Maximalwert durch, bei dessen Erreichen sie sich über ihren Freigabe-Eingang E selbst blockieren, es sei denn, es erfolgt zwischenzeitlich doch noch eine Rücksetzung. Der n-bit-Multiplexer 33 übernimmt die Ausgangszustände der Zähler 30 bis 33 und bildet am Ausgang 34 ein zeitbewertetes n-bit-Multiplexsignal.

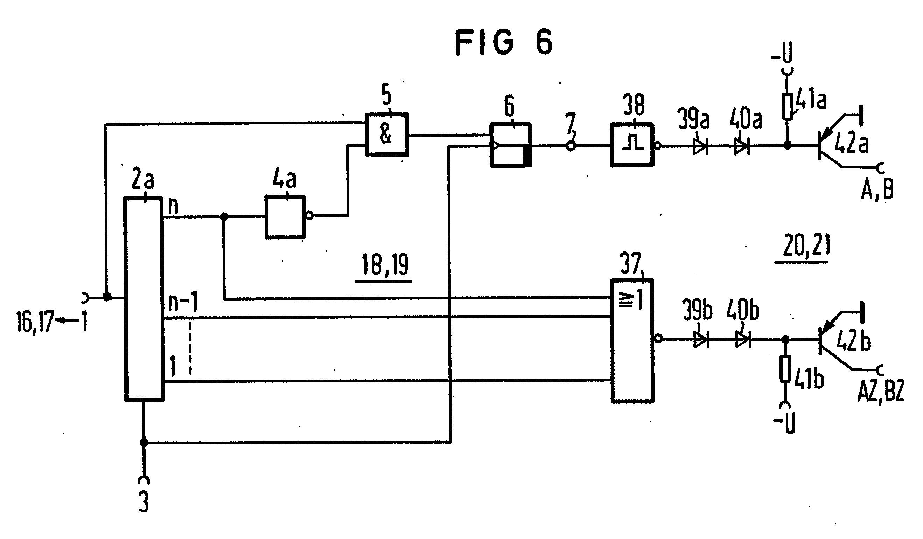

Figur 6 zeigt links eine Anordnung zur Erkennung einer logischen Zustandsänderung in einem Kanal eines n-bit-Multiplexsignals, die im wesentlichen bereits in Figur 1 gezeigt ist und in Figur 3 die Bezugszeichen 18 oder 19 trägt. Auf der rechten Seite der Figur 6 ist ein Umsetzer 20 oder 21 nach Figur 3 gezeigt.

Der linke Teil enthält die Elemente 1, 2, 4a, 5, 6 und 7 wie in Figur 1. Ein n-bit-Schieberegister 2a ist detaillierter dargestellt als das n-bit-Schieberegister 2 in Figur 1. Es enthält Ausgänge für n bit.

Der rechte Teil der Zeichnung enthält einen Umsetzer 20 oder 21 mit einem NOR-Gatter 37, ein Monoflop 38, Dioden 39a, 39b, 40a und 40b, Widerstände 41a und 41b und Transistoren 42a und 42b.

Wird an den Eingang 1 ein n-bit-Multiplexsignal angelegt, dann erscheint am Ausgang 7 des D-Flipflops 6 bei einer Zustandsänderung in einem Kanal ein Signal. Dieses bringt das Monoflop 38 für eine definierte Zeit zum Kippen, was für diese Zeit über den Transistor 42a einen A- bzw. B-Alarm auslöst. Während das Monoflop 38 nur auf eine einzelne Zustandsänderung im n-bit-Multiplexsignal anspricht, gibt das NOR-Gatter 37 bei einem Alarm in irgendeinem Kanal ein Signal aus, das über den Transistor 42b ein Dauersignal auf der Zustandsleitung AZ bzw. BZ auslöst.

## Patentansprüche

Anordnung zur Überwachung eines PCM- oder DS-Geräts oder eines Digitalsignal-Kanalverteilers für n-bit-Multiplexsignale, dadurch gekennzeichnet, daß Fehler- und Störerkennungseinrichtungen (11, 12, 13) vorgesehen sind, daß eine Verknüpfungseinrichtung (15) vorgesehen ist, die über einen Alarmbus (14) mit den Fehler- und Störerkennungseinrichtungen (11, 12, 13) verbunden ist, daß eine erste Zeitbewertungseinrichtung (16) vorgesehen ist, die A-Alarme (AA) von der Verknüpfungseinrichtung (15) empfängt, daß eine zweite Zeitbewertungseinrichtung (17) vorgesehen ist, die B-Alarme (BA) von der Verknüpfungseinrichtung (15) empfängt, daß eine erste Anordnung (18) zur Erkennung einer logischen Zustandsänderung vorgesehen ist, deren Eingang mit dem Ausgang der ersten Zeitbewertungseinrichtung (16) verbunden ist, daß eine zweite Anordnung (19) zur Erkennung einer logischen Zustandsänderung vorgesehen ist, deren Eingang mit dem Ausgang der zweiten Zeitbewertungseinrichtung (17) verbunden ist, daß in beiden Anordnungen (18, 19) jeweils ein n-bit-Schieberegister (2), dessen Eingang als Gesamteingang (1) dient und das einen Multiplextakteingang (3) aufweist, ein UND-Gatter (5), dessen erster Eingang - für eine Erkennung einer logischen Zustandsänderung von einem niedrigen Wert zu einem hohem Wert unmittelbar mit dem Gesamteingang (1) und dessen zweiter Eingang über einen Inverter (4a) mit dem Ausgang des n-bit-Schieberegisters (2) verbunden ist und dessen erster Eingang - für eine Erkennung einer logischen Zustandsänderung von einem hohen Wert zu einem niedrigen Wert - über einen Inverter (4b) mit dem Gesamteingang (1) und dessen zweiter Eingang unmittelbar mit dem Ausgang des n-bit-Schieberegisters (2) verbunden ist, und ferner ein D-Flip-Flop (6) vorgesehen sind, dessen Eingang mit dem Ausgang des UND-Gatters (5) und dessen Takteingang mit dem Multiplextakteingang (3) verbunden ist und dessen Ausgang als Gesamtausgang (7) dient, daß ein erster Umsetzer (20) vorgesehen ist, dessen Eingang mit dem Ausgang der ersten Anordnung (18) zur Erkennung einer logischen Zustandsänderung, dessen erster Ausgang mit einer A-Alarmimpuls-Signalleitung (A) und dessen zweiter Ausgang mit einer A-Daueralarm-Signalleitung (AZ) verbunden ist, und daß ein zweiter Umsetzer (21) vorgesehen ist, dessen Eingang mit dem Ausgang der zweiten Anordnung (19) zur Erkennung einer logischen Zustandsänderung, dessen erster Ausgang mit einer B-Alarmimpuls-Signalleitung (B) und dessen zweiter Ausgang mit einer B-Daueralarm-Signalleitung (BZ) verbunden ist.

## Claims

Arrangement for monitoring a PCM or DS device or a digital signal channel distributor for n-bit multiplex signals, characterized in that error and fault detection devices (11, 12, 13) are provided, in that a logic element (15) is provided which is connected via an alarm bus (14) to the error and fault detection devices (11, 12, 13), in that a first time evaluation device (16) is provided which receives A-alarms (AA) from the logic element (15), in that a second time evaluation device (17) is provided which receives B-alarms (BA) from the logic element (15), in that a first arrangement (18) is provided for detecting a logic state change, the input of which is connected to the output of the first time evaluation device (16), in that a second arrangement (19) is provided for detecting a logic state change, the input of which is connected to the output of the second time evaluation device (17), in that in both arrangements (18, 19) there are provided in each case an n-bit shift register (2), the input of which serves as composite input (1) and which has a multiplex clock input (3), an AND gate (5), the first input of which - for detecting a logic state change from a low value to a high value - is connected directly to the composite input (1), and the second input of which is connected via an inverter (4a) to the output of the n-bit shift register (2) and the first input of which - for detecting a logic state change from a high value to a low value - is connected via an inverter (4b) to the composite input (1) and the second input of which is connected directly to the output of the n-bit shift register (2), and furthermore a D-type flipflop (6), the input of which is connected to the output of the AND gate (5) and the clock input of which is connected to the multiplex clock input (3) and the output of which serves as composite output (7), in that a first converter (20) is provided, the input of which is connected to the output of the first arrangement (18) for detecting a logic state change, the first output of which is connected to an A-alarm pulse signalling line (A) and the second output of which is connected to an A-continuous alarm signalling line (AZ), and in that a second converter (21) is provided, the input of which is connected to the output of the second arrangement (19) for detecting a logic state change, the first output of which is connected to a B-alarm pulse signalling line (B) and the second output of which is connected to a B-continuous alarm signalling line (BZ).

**Revendications**

Dispositif pour contrôler un appareil MIC ou à signaux numériques ou un répartiteur de canaux de transmission de signaux numériques pour des signaux multiplex à n bits, caractérisé par le fait qu'il est prévu des dispositifs (11, 12, 13) d'identification de défauts et de perturbations, qu'il est prévu un dispositif combinatoire (15), qui est relié par l'intermédiaire d'un bus d'alarme (14) aux dispositifs (11, 12, 13) d'identification de défauts et de perturbations, qu'il est prévu un premier dispositif de pondération temporelle (16), qui reçoit des alarmes A (AA) de la part du dispositif combinatoire (15), qu'il est prévu un second dispositif de pondération temporelle (17), qui reçoit des alarmes B (BA) de la part du dispositif combinatoire (15), qu'il est prévu un premier dispositif (18), qui sert à identifier un changement d'état logique et dont l'entrée est reliée à la sortie du premier dispositif de pondération temporelle (16), qu'il est prévu un second dispositif (19), qui sert à identifier un changement d'état logique et dont l'entrée est raccordée à la sortie du second dispositif de pondération temporelle (17), que dans les deux dispositifs (18, 19), il est prévu respectivement un registre à décalage à n bits (2), dont l'entrée est utilisée comme entrée commune (1) et qui possède une entrée de cadence multiplex (3), une porte ET (5), dont la première entrée est reliée directement à l'entrée commune (1) - pour l'identification d'un changement d'état logique d'une valeur faible à une valeur élevée - et dont la seconde entrée est reliée par l'intermédiaire d'un inverseur (4a) a la sortie du registre à décalage à n bits (2) et dont la première entrée est reliée par l'intermédiaire d'un inverseur (4b) à l'entrée commune (1) - pour l'identification d'un changement d'état logique d'une valeur élevée à une valeur faible - et dont la seconde entrée est reliée directement à la sortie du registre à décalage à n bits (2), et en outre une bascule bistable de type D (6), dont l'entrée est raccordée à la sortie de la porte ET (5) et dont l'entrée de cadence est raccordée à l'entrée de cadence multiplex (3) et dont la sortie est utilisée en tant que sortie commune (7), qu'il est prévu un premier convertisseur (20), dont l'entrée est reliée à la sortie du premier dispositif (18) servant à identifier un changement d'état logique, dont la première sortie est raccordée à une ligne (A) de transmission de signaux impulsionnels d'alarme A et dont la seconde sortie est reliée à une ligne (AZ) de transmission de signaux d'alarme permanente A, et qu'il est prévu un second convertisseur (21) dont l'entrée est reliée à la sortie du second dispositif (19) servant à identifier un changement d'état logique, dont la première sortie est reliée à une ligne (B) de transmission de signaux impulsionnels d'alarme B et dont la seconde sortie est reliée à une ligne (BZ) de transmission de signaux d'alarme permanente B.

FIG 1

FIG 2

FIG 3

FIG 4

FIG 5

# FIG 6

EP 0 211 213 B1